# EUROPÄISCHE PATENTANMELDUNG

(11) **EP 4 712 714 A1**
(43) Veröffentlichungstag der Anmeldung: **18.03.2026**
(21) Anmeldenummer: 25195143.0
(22) Anmeldetag: 11.08.2025
(51) Int. Cl.: H05K 9/00

(54) **MAGNETFELDABSCHIRMMATTE, SYSTEM MIT EINER MAGNETFELDABSCHIRMMATTE**

(30) Priorität: 11.09.2024 DE 102024126057
(71) Anmelder: RWE Offshore Wind GmbH, 45141 Essen (DE)
(72) Erfinder: Offermann, Michael, 41517 Grevenbroich (DE); Obermeyer, Sebastian, 21147 Hamburg (DE)
(74) Vertreter: Cohausz & Florack

(57) **Zusammenfassung**

Magnetfeldabschirmmatte mit zumindest einem drahtförmigen Leiter mit einem Leiterkern aus einem elektrisch leitfähigen Material und einer dem Leiterkern zumindest in Teilen umgebenden elektrischen Isolation aus einem elektrisch isolierenden Material, und zumindest zwei aus dem Leiter gebildeten, flächig angeordneten Leiterschleife, wobei die zumindest zwei der Leiterschleifen in der Art eines Endlosbandes zumindest mechanisch miteinander verbunden sind.

## Beschreibung

Der Gegenstand betrifft eine Magnetfeldabschirmmatte, ein System mit einer Magnetfeldabschirmmatte sowie ein Verfahren zum Verlegen einer Magnetfeldabschirmmatte. Hierzu zählen Verfahren und Vorrichtungen zum Schutz gegen unerwünschte Ausstrahlung von magnetischen Wechselfeldern, die durch Hochspannungsleitungen erzeugt werden.

Insbesondere umfasst der Gegenstand auch Magnetfeldabschirmmatten für Anwendungen im Tiefbau, wie z.B. bei der Verlegung und Wartung von Hochspannungsleitungen onshore oder offshore. Im Nachfolgenden werden die Begriffe Hochspannungsleitung, oder Trasse auch synonym verwendet.

Der Gegenstand ist auf die Lösung von Problemen mit magnetischen Felder bezogen, die sich durch den Betrieb von Hochspannungsleitungen, insbesondere im Tiefbau, onshore oder offshore, ergeben. Der Gegenstand bezieht sich insbesondere auf die Verwendung und Verlegung von Magnetfeldabschirmmatten für Hochspannungsleitungen im Offshore oder Onshore Bereich. Offshore werden Hochspannungsleitungen häufig zwischen Windkraftanlagen oder Erzeugungsanlangen untereinander oder von Windkraftanlagen zu Substations verlegt. Auch werden Hochspannungsleitungen zwischen Substations untereinander oder von eine Substation zu einer onshore Transition Joint Bay verlegt. Bei geringer Wassertiefe werden die Hochspannungsleitungen auf oder in dem Meeresboden verlegt. Auch werden Hochspannungsleitungen onshore auf oder im Untergrund verlegt. Im Nachfolgenden ist der Begriff Hochspannungsleitung insbesondere im Sinne einer Erdleitung zu verstehen, die unterirdisch oder oberirdisch verlegt ist. Insbesondere ist keine Freileitung darunter zu verstehen, welche an Masten frei in der Luft hängend montiert ist.

Eine Hochspannung im vorliegenden Sinn kann eine Spannung von über 1kV sein. Insbesondere kann eine Spannung von bis zu 10-20kV gemeint sein. Auch kann eine Spannung bis zu 110kV gemeint sein. Darüber hinaus kann eine Hochspannung auch eine Spannung von 220 - 400kV sein. Insbesondere sind die Spannungsebenen Mittelspannung, Hochspannung und Höchstspannung vom Begriff Hochspannungsleitung umfasst.

Der Stand der Technik im Bereich der Hochspannungsleitungen weist erhebliche Mängel hinsichtlich des Schutzes vor Magnetfeldern auf. Im derzeitigen Stand der Technik kommt es insbesondere bei im Tiefbau verlegten Hochspannungsleitungen zu erheblicher Abstrahlung magnetischer Felder in unmittelbarer räumlicher Nähe zu Flora und Fauna, anders als dies bei Freileitungen ist, die aufgrund ihrer Verlegung bereits mehrere 10Meter von Flora und Fauna entfernt verlaufen. Insbesondere bei Wechselstromleitungen kommt es sowohl im Nahfeld als auch im Fernfeld dieser Wechselstromleitungen zu magnetischen Wechselfeldern mit einer erheblichen magnetischen Feldstärke.

Die den stromdurchflossenen Leiter der Hochspannungsleitung umgebenden magnetischen Felder können sich, insbesondere bei Starkstromleitungen mit Strömen jenseits 10A, negativ auf die Umwelt auswirken. Auch können sie dazu beitragen, dass sensible Schwingungs- und Messeinrichtungen gestört werden oder dass empfindliche Geräte durch magnetische Störungen beeinträchtigt werden.

Darüber hinaus können die magnetischen Felder auch negative Auswirkungen auf Menschen und Tiere haben. Insbesondere kann eine langfristige Exposition gegenüber starken magnetischen Feldern zu Gesundheitsproblemen führen.

Somit lag dem Gegenstand die Aufgabe zugrunde, eine effektive Dämpfung und/oder Abschirmung von magnetischen Fernfeldern bei Hochspannungsleitungen im Tiefbau zu erreichen.

Zur Lösung dieser Aufgabe wird gemäß einem Aspekt eine Magnetfeldabschirmmatte nach Anspruch 1 vorgeschlagen. Die gegenständliche Magnetfeldabschirmmatte dient dazu, magnetische Felder zu absorbieren und/oder abzuschirmen und/oder zu dämpfen. Der Begriff Abschirmen kann auch als Dämpfen, Kompensieren oder Absorbieren verstanden werden. Diese Begriffe werden vorliegend als Synonyme verwendet.

Insbesondere wird durch die gegenständliche Magnetfeldabschirmmatte eine Abschirmung des magnetischen Fernfelds, also insbesondere in einem Abstand von mehreren Zentimetern, insbesondere mehr als 50cm, bevorzugt mehr als 100cm zu dem Kabel erzielt. Die Magnetfeldabschirmmatte ist dazu eingerichtet, ein magnetisches Gegenfeld zu erzeugen, dessen Feldlinien im Wesentlichen entgegengesetzt zu den Feldlinien des magnetischen Feldes des Kabels verlaufen. Im Fernfeld des Kabels kompensieren sich die magnetischen Feldlinien des Kabels und der Abschirmmatte im Wesentlichen.

Für die Magnetfeldabschirmmatte wird ein drahtförmiger Leiter mit einem Leiterkern aus einem elektrisch leitfähigen Material und einer den Leiterkern zumindest in Teilen umgebenden elektrischen Isolation aus einem elektrisch isolierenden Material vorgeschlagen. Auch umfasst ist eine vollständig umlaufende Isolation des Leiterkerns mit dem elektrisch isolierenden Material.

Ein elektrisch leitfähiges Material kann beispielsweise Kupfer oder eine Legierung hiervon oder Aluminium oder eine Legierung hiervon sein, während ein elektrisch isolierendes Material wie Keramik, PE, PVC, PP, Silikon oder dergleichen verwendet werden kann.

Ein Vorteil der beanspruchten Anordnung liegt darin, dass sie durch Selbstinduktion in der Leiterschleife magnetische Gegenfelder erzeugen kann, um das von dem Kabel abgestrahlte magnetische Feld zu dämpfen. Dies kann dazu beitragen, die Auswirkungen des magnetischen Feldes auf die Umwelt und die Menschen zu minimieren.

Der Leiter der Magnetfeldabschirmmatte ist derart angeordnet, dass er eine flächige Leiterschleife bildet. Dabei ist der Leiter der Magnetfeldabschirmmatte bevorzugt im Wesentlichen in einer Ebene verlaufend verlegt. Der Leiter der Magnetfeldabschirmmatte ist kann zu einer geschlossenen oder offenen Leiterschleife geformt sein. Die Magnetfeldabschirmmatte kann mechanisch flexibel sein.

Die Magnetfeldabschirmmatte kann zum Verlegen auf dem Untergrund gebildet sein. Im verlegten Zustand kann sich die Magnetfeldabschirmmatte an den Untergrund anschmiegen. Insbesondere kann die Magnetfeldabschirmmatte und/oder der Leiter (die Leiterschleife) der Magnetfeldabschirmmatte mechanisch biegeschlaff sein, also derart, dass sie sich durch ihr Eigengewicht plastisch verformen kann. Im verlegten Zustand, also insbesondere bei einer Verlegung auf dem Untergrund, liegt der Leiter entlang der Leiterschleife ggf. nicht mehr in einer Ebene.

Die Magnetfeldabschirmmatte kann aus einem Substrat und dem Leiter gebildet sein. Der Leiter kann an dem Substrat fixiert sein und/oder auf das Substrat aufgelegt sein oder mit dem Substrat verbunden sein oder mit dem Substrat verwoben sein. Auch kann die Magnetfeldabschirmmatte ausschließlich aus dem Leiter gebildet sein. Der Leiter kann in Maschenform gebildet sein und die Leiterschleife bilden. Der Leiter kann sich entlang der Leiterschleife kreuzen.

Im gefertigten Zustand können zwei oder mehr Leiterschleifen in der Art eines Endlosbandes miteinander verbunden sein. Zumindest zwei Leiterschleifen können nebeneinander in Breitenrichtung zueinander liegen und miteinander verbunden sein. Zumindest zwei Leiterschleifen können nebeneinander in Längsrichtung zueinander liegen und miteinander verbunden sein.

Im gefertigten Zustand kann das Substrat als Endlosband gebildet sein. Auf dem Substrat können in Breitenrichtung zwei oder mehr Leiterschleifen, verbunden oder unverbunden, nebeneinander liegen. Auf dem Substrat können in Längsrichtung zwei oder mehr Leiterschleifen, verbunden oder unverbunden, nebeneinander liegen. Zumindest jeweils zwei nebeneinander liegende Leiterschleifen können miteinander verbunden sein.

Die Magnetfeldabschirmmatte kann in einem Endlosprozess gefertigt werden. Die Magnetfeldabschirmmatte kann auf eine Trommel oder ein Coil aufgewickelt werden. Zum Verlegen kann die Magnetfeldabschirmmatte von der Trommel oder dem Coil abgewickelt werden. Zum Verlegen kann die Magnetfeldabschirmmatte auf dem Untergrund, oberhalb des Kabels verlegt werden. Endlos in diesem Zusammenhang kann so verstanden werden, dass bei der Herstellung die Erstreckung des Endlosbandes in seiner Längsrichtung ein Vielfaches, bevorzugt um zumindest einen Faktor 10, bevorzugt zumindest mehr als um den Faktor 100 größer ist als die Erstreckung des Endlosbandes in seiner Breitenrichtung.

Ein weiterer Vorteil der gegenständlichen Anordnung kann darin liegen, dass die Magnetfeldabschirmmatte leicht zu montieren ist. Die Magnetfeldabschirmmatte kann unkompliziert entlang einer Trasse über der Energieleitung angebracht werden, um die Abschirmung des magnetischen Feldes zu ermöglichen. Die Magnetfeldabschirmmatte liegt über dem Kabel und schirmt das magnetische Feld im Raum oberhalb des Kabels ab oder dämpft dieses. Zwar erfolgt keine Abschirmung oder Dämpfung des Magnetfeldes nach unten, in den Boden hinein, dennoch reduziert die gegenständliche Magnetfeldabschirmmatte das Magnetfeld oberhalb der Energieleitung.

Die Verwendung von elektrisch leitfähigen Materialien in dem Kabel kann das induzierte Gegenfeld optimieren. Die Auswirkungen des magnetischen Feldes der Energieleitung auf die Umwelt kann durch ein möglichst gleich großes induziertes Gegenfeld minimiert werden. Die Isolation der Leitung der Magnetfeldabschirmmatte kann dazu beitragen, dass die Leitung der Magnetfeldabschirmmatte sicher und widerstandsfähig ist.

Insgesamt bietet die Magnetfeldabschirmmatte eine einfache und effektive Möglichkeit, magnetische Felder zu absorbieren oder abzuschirmen und damit deren Auswirkungen auf die Umwelt und die Menschen zu minimieren.

Gemäß einem Ausführungsbeispiel wird vorgeschlagen, dass der Leiter in der Leiterschleife mäanderförmig mit wechselseitig im Wesentlichen parallel zueinander verlaufenden Abschnitten verläuft. Der Leiter verläuft entlang der Leiterschleife mäanderförmig, was bedeuten kann, dass sich in Erstreckungsrichtung des Leiters nacheinander winklig zueinander verlaufende Abschnitte erstrecken. Einander folgende Abschnitte können winklig zueinander sein. Es können sich jeweils zwei oder mehr Abschnitte abwechselnd wiederholen. Abschnitte können kurvenförmig oder gerade verlaufen. Kurvenförmige und gerade Abschnitte können einander abwechseln. Nebeneinander verlaufende gerade Abschnitte verlaufen bevorzugt antiparallel zueinander. Hierunter kann verstanden werden, dann in nebeneinander verlaufenden Abschnitten deren Stromflussrichtung bei gleichem Strom entgegengesetzt sind. Die Mäanderförmigkeit kann dazu beitragen, dass die vom magnetischen Fluss des von der Energieleitung stammenden Magnetfeldes durchströmte Fläche der Leiterschleife vergrößert ist und somit der in der Leiterschleife induzierte Strom ebenfalls vergrößert ist. Die Mäanderförmigkeit des Leiters ermöglicht eine vergrößerte Fläche, die vom Leiter umschlossen wird. In der Folge ist das magnetische Gegenfeld vergrößert gegenüber einer Leiterschleife mit einer kleineren umgriffenen Fläche.

Gemäß einem Ausführungsbeispiel wird vorgeschlagen, dass zumindest zwei Bereiche der Leiterschleife mit bevorzugt jeweils mäanderförmigen, bevorzugt wechselseitig im Wesentlichen parallel zueinander verlaufenden Leitern entlang einer Längsrichtung der Leiterschleife gespiegelt sind. Die Leiterschleife kann in Abschnitten verlaufen, die sich in Längsrichtung nacheinander erstrecken und bevorzugt wechselseitig im Wesentlichen parallel zueinander verlaufen.

Zumindest zwei Bereiche der Leiterschleife haben jeweils mäanderförmige, bevorzugt wechselseitig im Wesentlichen parallel zueinander verlaufende Leiter, die entlang einer Längsrichtung der Leiterschleife gespiegelt sind. Die gespiegelte Anordnung der Bereiche kann bedeuten, dass sie entlang einer Längsrichtung der Leiterschleife nacheinander angeordnet sind. So folgen in Längsrichtung zwei oder mehr Leiterschleifen aufeinander, welche dieselbe Form haben.

Gemäß einem Ausführungsbeispiel wird vorgeschlagen, dass zumindest zwei Bereiche der Leiterschleife mit jeweils mäanderförmigen, bevorzugt wechselseitig im Wesentlichen parallel zueinander verlaufenden Leitern, entlang einer Querrichtung der Leiterschleife gespiegelt sind. Die gespiegelte Anordnung der Bereiche kann bedeuten, dass sie entlang einer Querrichtung der Leiterschleife nebeneinander angeordnet sind. So liegen in Querrichtung zwei oder mehr Leiterschleifen nebeneinander, welche dieselbe Form haben.

Die Querrichtung verläuft bevorzugt senkrecht zur Längsrichtung. In Längsrichtung können sich die gespiegelten Bereiche wiederhohlen.

Gemäß einem Ausführungsbeispiel wird vorgeschlagen, dass die Leiterschleife elektrisch geschlossen ist. Eine elektrisch geschlossene Leiterschleife kann als eine Schleife verstanden werden, bei der die Leiterenden an beiden Enden miteinander elektrisch verbunden sind. Die Verwendung einer elektrisch geschlossenen Leiterschleife hat den Vorteil, dass das magnetische Feld innerhalb der Leiterschleife einen Strom induzieren kann. Bei einem Wechselfeld wird innerhalb der Leiterschleife ein Strom induziert. Dieser Strom wiederum erzeugt ein magnetisches Gegenfeld, welches zumindest im Fernbereich das magnetische Feld des Kabels dämpft oder kompensiert.

Gemäß einem Ausführungsbeispiel wird vorgeschlagen, dass der Leiter einer der Leiterschleifen an seinen Enden mit einem elektrischen Treiber verbunden ist, wobei der Treiber dazu eingerichtet ist, einen elektrischen Strom in den Leiter einzuprägen. Im Gegensatz zu dem vorherigen Beispiel kann vorliegend ein Strom in den Leiter durch einen Treiber eingespeist werden. Dies kann z.B. dann sinnvoll sein, wenn ein Gleichstromkabel abgeschirmt werden soll. Ein Gleichstromkabel erzeugt ein statisches magnetisches Feld um das Kabel herum, weshalb in der Leiterschleife der Magnetfeldabschirmmatte kein magnetisches Wechselfeld verläuft und daher kein Strom induziert wird. Der induzierte Strom ist nämlich abhängig von der zeitlichen Veränderung des magnetischen Flusses. Durch einen eingeprägten Strom, der z.B. antiparallel zum Strom in dem Gleichstromkabel verläuft, kann ein magnetisches Gegenfeld erzeugt werden, welches zumindest im Fernfeld das magnetische Feld des Gleichstromkabels kompensiert. Auch kann ein Treiber einen Wechselstrom in den Leiter einprägen. Dies kann z.B. in Anhängigkeit des Stroms in dem abzuschirmenden Kabel sein. So kann der eingeprägte Strom phasenverschoben, z.B. um 180° phasenverschoben sein. Das dadurch erzeugte Magnetfeld kompensiert das Magnetfeld des abzuschirmenden Kabels. Die Phasendifferenz zwischen der Phase des eingeprägten Stroms und der Phase des Stroms in dem Kabel kann abhängig von einem Abstand zwischen der Magnetfeldabschirmmatte und dem Kabel eingestellt sein.

Ein elektrischer Treiber kann als ein Gerät verstanden werden, das einem Strom in den Leiter der Leiterschleife einleitet oder einprägt. Ein Sensor kann den Betrag und/oder die Phase des Stroms in dem Kabel messen. Hierzu kann z.B. eine Rogiwski Spule eingesetzt werden. Abhängig von gemessenen Sensorwert kann der Treiber den Strom in den Leiter der Leiterschleife einspeisen. Ein Sensor kann mit einer Mehrzahl von Treibern verbunden sein. Ein Treiber kann mit einer Mehrzahl von Leiterschleifen verbunden sein.

Gemäß einem Ausführungsbeispiel wird vorgeschlagen, dass die Leiterschleife mit einem Flächengebilde verbunden ist, insbesondere dass die Leiterschleife mit einem textilen Flächengebilde verbunden ist. Das Flächengebilde kann das Substrat sein. Das Flächengebilde kann aus einem Kunststoff gebildet sein. Das Flächengebilde kann bevorzugt ein textiles Flächengebilde, woven (Gewebe), non-woven (Vlies, Filz) oder dergleichen sein. Ein Gewebe kann aus einer Reihe von "Fäden" und/oder "Schüssen" gebildet ist, die miteinander verbunden sind. Diese "Fäden" oder "Schüsse" können durch den Leiter gebildet sein. Das Flächengebilde kann der Leiterschleife mechanische Stabilität verleihen. Das Flächengebilde kann elektrisch nichtleitend sein. Das Flächengebilde kann mit der Leiterschleife mechanisch verbunden sein, insbesondere kraft- und/oder formschlüssig.

Durch das Flächengebilde kann die geometrische Struktur der Leiterschleife auf dem Substrat fixiert werden. Der Verlauf des Leiters entlang der Leiterschleife kann relativ zum Flächengebilde fixiert werden. Hierdurch kann die vom Magnetfeld durchströmte Fläche definiert bleiben. Das Flächengebilde erleichtert die Verlegung der Leiterschleife auf dem Untergrund.

Gemäß einem Ausführungsbeispiel wird vorgeschlagen, dass die Leiterschleife mit einem wasserdurchlässigen Flächengebilde verbunden ist. Die Verbindung der Leiterschleife mit einem wasserdurchlässigen Flächengebilde ermöglicht eine flexible und robuste Konfiguration, die sowohl in trockenen als auch feuchten Umgebungen eingesetzt werden kann. Ein wasserdurchlässiges Flächengebilde kann als ein Gebilde verstanden werden, das Wasserzellen oder Poren enthält, die Wasser hindurchlassen, aber auch mechanische Belastungen absorbieren können. Bei der Verlegung in ökologisch sensiblen Bereichen ist die Wasserdurchlässigkeit ein wesentliches Kriterium für die Akzeptanz der Magnetfeldabschirmmatte. Es versteht sich von selbst, dass die Leiterschleife ebenfalls wasserdurchlässig ist.

Ein weiterer Vorteil der Wasserdurchlässigkeit besteht darin, dass sie eine flexible und robuste Magnetfeldabschirmung ermöglicht, die in verschiedenen Umgebungen eingesetzt werden kann. Die Verwendung eines wasserdurchlässigen Flächengebildes ermöglicht es, die Magnetfeldabschirmung auch in feuchten oder nassen Umgebungen zu verwenden, ohne dass sie beschädigt wird oder dass der Boden versiegelt wird.

Gemäß einem Ausführungsbeispiel wird vorgeschlagen, dass die Leiterschleife aus miteinander verbundenen Maschen gebildet ist, insbesondere dass die Leiterschleife aus miteinander verbundenen Maschen mit einer Maschenweite von mehr als 2cm und weniger als 10cm, insbesondere zwischen 2 und 5cm gebildet.

Die Verwendung von miteinander verbundenen Maschen für die Leiterschleife ermöglicht eine flexible und robuste Konfiguration. Ein Netz oder ein Gitter sind Beispiele für Magnetfeldabschirmmatten, die aus miteinander verbundenen Maschen gebildet sind. Die Leiterschleife wird durch die miteinander verbundenen Maschen gebildet. Die Maschen können unterschiedliche Größen haben, wobei die Verwendung von Maschen mit einer einheitlichen Größe, wie z.B. zwischen 2 und 5cm, bevorzugt ist, da dies eine einfache Herstellung ermöglicht. Die miteinander verbundenen Maschen können leicht produziert werden, indem sie auf ein Substrat oder aufeinander gelegt werden. Dies reduziert die Kosten und die Zeit, die für die Herstellung der Leiterschleife benötigt wird.

Die Maschenweite kann relevant für die Dichte des erzeugten Gegenfeldes sein. Je weiter die Maschen auseinander liegen, desto größer ist die vom Magnetfeld des Kabels durchströmte Fläche. Auf der anderen Seite wirkt das Magnetfeld, welches durch den induzierten Strom in der Leiterschleife erzeugt wird, auf ein größeres Volumen und die magnetische Flussdichte und mithin die Magnetfeldstärke sind entsprechend geringer. Es hat sich gezeigt, dass eine Maschenweite zwischen 2cm und 5cm einen guten Kompromiss darstellt.

Die Leiterschleife kann durch die Verwendung von miteinander verbundenen Maschen gebildet sein. Die Maschen können als ein Netz oder Gitter beschrieben werden. Die Verwendung von miteinander verbundenen Maschen für die Leiterschleife ermöglicht eine mechanisch flexible und gleichzeitig robuste Konfiguration. Die Maschen können unterschiedliche Größen haben, wobei die Verwendung von Maschen mit einer bestimmten Größe, wie z.B. zwischen 2 und 5cm, bevorzugt ist.

Die miteinander verbundenen Maschen können leicht produziert werden, indem sie auf ein Substrat und/oder aufeinander gelegt werden. Dies reduziert die Kosten und die Zeit, die für die Herstellung der Leiterschleife benötigt wird.

Gemäß einem Ausführungsbeispiel wird vorgeschlagen, dass die Leiterschleife als Kettenmatte gebildet ist. Eine Kettenmatte kann aus miteinander verbundenen, aber zueinander beweglichen Kettengliedern gebildet sein. Ein Kettenglied kann ein Ring sein. Eine Kettenmatte ist mechanisch flexibel und kann bei der Verlegung leicht an den Untergrund angepasst werden, um den spezifischen Anforderungen der Anwendung zu entsprechen.

Gemäß einem Ausführungsbeispiel wird vorgeschlagen, dass jeweils eine Leiterschleife eine Erstreckung in einer Längsrichtung des Endlosbandes aufweist, welche um zumindest einen Faktor 2, bevorzugt um einen Faktor 5 größer ist, als eine Erstreckung in einer Querrichtung des Endlosbandes. Ein Band mit einer entsprechenden Erstreckung in Längsrichtung kann als Endlosband verstanden werden. Eine gegenständliche Leiterschleife kann nach der Herstellung auf ein Coil aufgewickelt werden und vor Ort, bei der Verlegung von dem Coil abgewickelt werden.

Gemäß einem Ausführungsbeispiel wird vorgeschlagen, dass das Endlosband als Kabelmarkierungsband gebildet ist. Im Tiefbau wird regelmäßig oberhalb einer im Tiefbau verlegten Energieleitung ein Kabelmarkierungsband verlegt. Die Funktion des Kabelmarkierungsbandes kann durch die gegenständliche Magnetfeldabschirmmatte übernommen werden. Die Magnetfeldabschirmmatte kann oberhalb des Kabels im Erdreich verlegt werden und somit das Kabel vor mechanischer Beschädigung schützen. Die Verwendung eines Kabelmarkierungsbandes als Magnetfeldabschirmmatte ermöglicht eine effektive Identifizierung und Markierung von Kabeln oder Leitungen.

Gemäß einem Ausführungsbeispiel wird vorgeschlagen, dass der Leiter aus einem metallischen Material, insbesondere aus Kupfer oder Legierungen davon, Aluminium oder Legierungen davon, Eisen oder Legierungen davon, insbesondere Stahl gebildet ist. Der Leiter sollte aus einem Material mit einem geringen spezifischen Widerstand hergestellt sein, um so ohmsche Verluste entlang der Leiterschleife zu minimieren und den induzierten Strom so wenig wie möglich zu beeinträchtigen. Ein Leiter kann auch als elektrischer Draht oder eine metallische Schiene bezeichnet werden. Gleichzeitig kann der Leiter aus einem korrosionsbeständigen Material sein. Insbesondere bei der Verwendung im Tiefbau oder Offshore kann es zu erheblichen chemischen Belastungen für den Leiter kommen. Insbesondere Kupfer, Aluminium, oder Legierungen davon sind geeignet, da sie gute elektrische Leitfähigkeiten aufweisen und leicht zu verarbeiten sind sowie eine gute Korrosionsbeständigkeit haben.

Gemäß einem weiteren Aspekt wird ein System mit einer Magnetfeldabschirmmatte nach Anspruch 14 vorgeschlagen. Dieses System weist eine zuvor beschriebene Magnetfeldabschirmmatte auf. Darüber hinaus weist das System zumindest ein Befestigungsmittel auf. Das Befestigungsmittel dient dazu, die Magnetfeldabschirmmatte mechanisch an einem Untergrund oder an einem unterhalb der Magnetfeldabschirmmatte verlaufenden Kabel mechanisch zu fixieren.

Das Befestigungsmittel kann verschiedenen Formen und Ausführungen haben, wie zum Beispiel einen Haken, einen Hering oder ein Gewicht. Ein Haken kann dazu dienen, die Magnetfeldabschirmmatte mit der Energieleitung mechanisch zu verbinden, während ein Hering sich dazu eignet, die Magnetfeldabschirmmatte am Untergrund zu befestigen. Ein Gewicht kann verwendet werden, um die Magnetfeldabschirmmatte auf dem Untergrund zu fixieren. Die Verwendung eines Befestigungsmittels bietet einige Vorteile. Zum Beispiel kann es die Magnetfeldabschirmmatte sicher und dauerhaft an ihrem Verlegeplatz fixieren. Weiterhin kann ein Befestigungsmittel dazu beitragen, die Abschirmung des Magnetfeldes zu verbessern, indem es sicherstellt, dass die Magnetfeldabschirmmatte räumlich nah am Kabel verlegt ist.

Gemäß einem Ausführungsbeispiel wird vorgeschlagen, dass unterhalb der Magnetfeldabschirmmatte eine Energieleitung verlegt ist und die Magnetfeldabschirmmatte in ihrer Längserstreckung im Wesentlichen entlang einer Längserstreckung der Energieleitung verlegt ist.

Die Magnetfeldabschirmmatte verläuft in einer Längserstreckung des Endlosbandes im Wesentlichen entlang einer Längserstreckung der Energieleitung. Die Matte kann räumlich nah an der Energieleitung angebracht sein und somit eine bestmögliche Abschirmwirkung erreicht wird.

Gemäß einem Ausführungsbeispiel wird vorgeschlagen, dass zumindest zwei Magnetfeldabschirmmatten in Querrichtung und/oder Längsrichtung nebeneinander verlegt sind. Es wird auch vorgeschlagen, dass eine Überdeckung zwischen zwei nebeneinander verlegten Magnetfeldabschirmmatten zumindest 10% und maximal 50% einer jeweiligen Quererstreckung beträgt.

Das System kombiniert zwei oder mehr Magnetfeldabschirmmatten, um eine verbesserte Abschirmwirkung zu erreichen. Die Verlegung von mindestens zwei Matten nebeneinander ermöglicht es, die Abschirmung von Magnetfeldern auf eine Weise zu optimieren, die nicht nur die magnetische Abschirmung selbst verbessert, sondern auch die Stabilität und Zuverlässigkeit des Systems als Ganzes erhöht. Eine Überdeckung kann bedeuten, dass nebeneinander liegende Matten sich überlappen oder übereinander liegen.

Die Verwendung von Magnetfeldabschirmmatten kann insbesondere in Situationen von großem Interesse sein, in denen sehr starke Magnetfelder auftreten oder in denen die Abschirmung von Magnetfeldern extrem wichtig ist. Zum Beispiel können diese Matten in industriellen Anwendungen eingesetzt werden, um die magnetische Verträglichkeit von Maschinen und Geräten zu verbessern.

Nachfolgend wird der Gegenstand anhand einer Ausführungsbeispiele zeigenden Zeichnung näher erläutert. In der Zeichnung zeigen:
- Fig. 1: eine schematische Ansicht einer Magnetfeldabschirmmatte;
- Fig. 2a, b: schematische Draufsichten auf eine Magnetfeldabschirmmatte;
- Fig. 4-6: schematische Draufsichten auf Magnetfeldabschirmmatten
- Fig. 8a, b: schematische Darstellungen von Systemen mit Magnetfeldabschirmmatte.

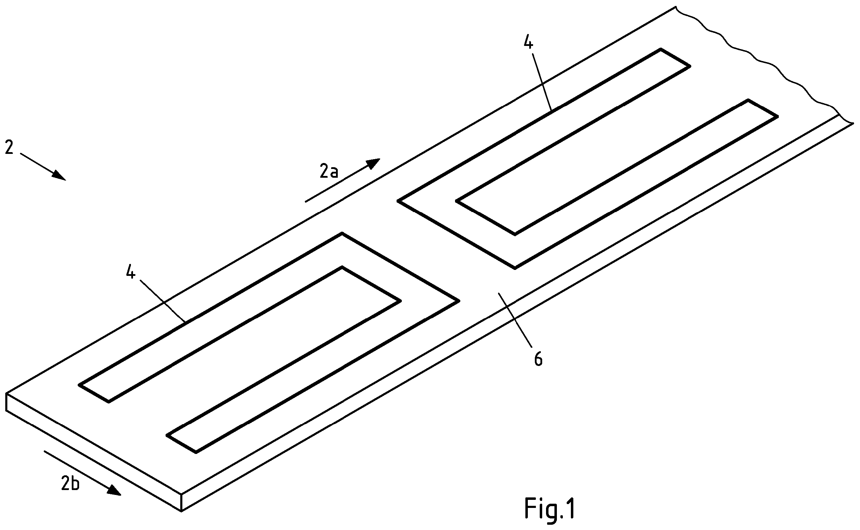

Fig. 1 zeigt eine Magnetfeldabschirmmatte 2 in einer schematischen Ansicht. Die Magnetfeldabschirmmatte erstreckt sich in einer Längsrichtung 2a und einer Querrichtung 2b.

Die Magnetfeldabschirmmatte 2 weist in Längsrichtung 2a zwei nebeneinander liegende Leiterschleifen 4 auf. Jede der Leiterschleifen 4 ist aus einem Leiter und ggf. einer den Leiter umgebenden Isolation gebildet. Die gezeigten Leiterschleifen 4 überlappen im gezeigten Beispiel nicht. Die Magnetfeldabschirmmatte 2 kann sich in Längsrichtung 2a über das gezeigte Maß hinaus erstrecken. Die Leiterschleife 4 ist auf einem Substrat 6 befestigt. Das Substrat kann z.B. ein Vlies sein.

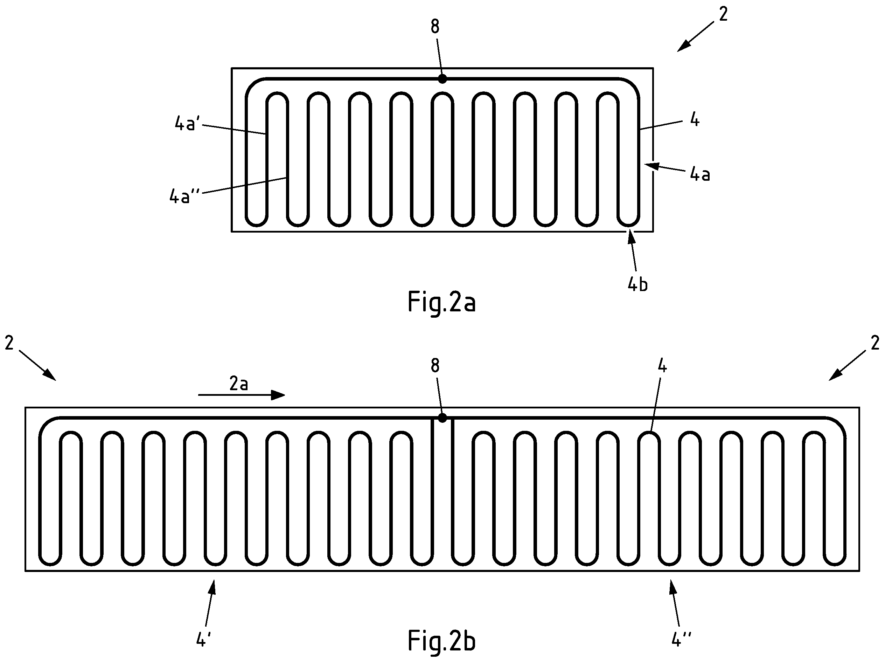

Fig. 2a zeigt eine Draufsicht auf eine Magnetfeldabschirmmatte 2. Auf der Magnetfeldabschirmmatte 2 ist eine Leiterschleife 4 angeordnet. Die Leiterschleife 4 weist gerade Abschnitte 4a und gekrümmte Abschnitte 4b auf. Zwei in Längsrichtung 2a nebeneinander angeordnete gerade Abschnitte 4a', 4a" verlaufen bei der gezeigten Leiterschleife 4 antiparallel. Die Leiterschleife 4 ist an den Enden 8 des Leiters kurzgeschlossen.

Fig. 2b zeigt eine zu Fig. 2a ähnliche Konfiguration. Im Unterschied zu Fig. 2a ist in Fig. 2b die Leiterschleife 4 aus in Längsrichtung 2a zueinander gespiegelten Leiterschleifen 4', 4" gebildet. Die Leiterschleifen 4', 4" sind darüber hinaus miteinander kurzgeschlossen.

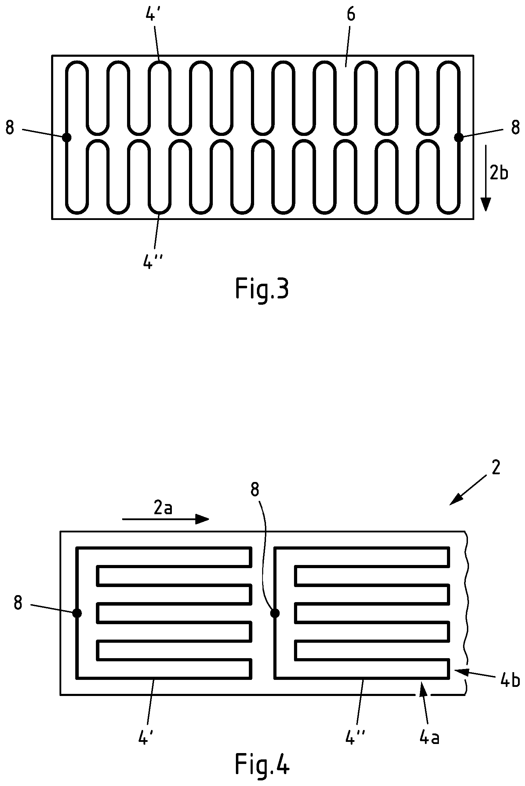

Fig. 3 zeigt ein weiteres Beispiel, bei dem zwei Leiterschleifen 4', 4" in Querrichtung 2b zueinander gespiegelt auf dem Substrat 6 aufliegen. Die Leiterschleifen 4', 4" sind an ihren Enden 8 miteinander kurzgeschlossen.

Fig. 4 zeigt ein weiteres Beispiel, bei dem zwei Leiterschleifen 4', 4" in Längsrichtung 2a nebeneinander angeordnet sind. Die Leiterschleifen 4', 4" sind jeweils an ihren Enden 8 kurzgeschlossen. Die Leiterschleifen 4', 4" sind zur Querachse zueinander gespiegelt. Bei den Leiterschleifen 4', 4" wechseln sich rechtwinklig zueinander verlaufende gerade Abschnitte 4a, 4b ab.

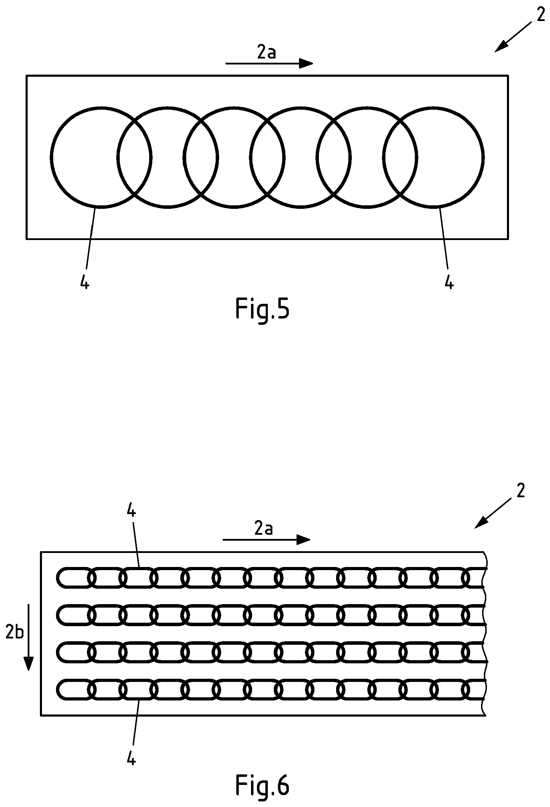

Fig. 5 zeigt ein weiteres Beispiel mit kreisförmig geschlossenen Leiterschleifen 4. Die Leiterschleifen liegen in Längsrichtung 2a nebeneinander und überlappen einander.

Fig. 6 zeigt ein weiteres Beispiel, bei dem Leiterschleifen 4 als Ketten gebildet sein. In Querrichtung 2b liegen mehr als zwei Ketten nebeneinander, überlappen einander aber nicht.

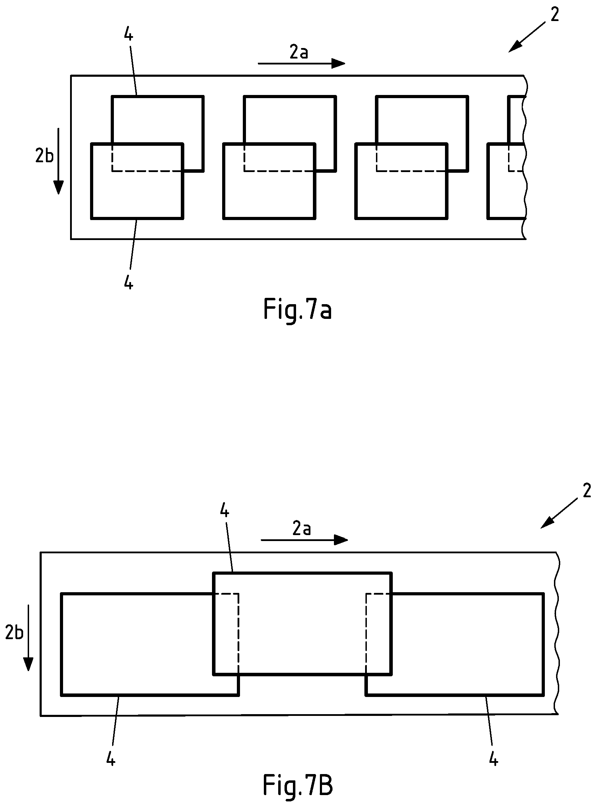

Fig. 7a zeigt eine als Endlosband gebildete Magnetfeldabschirmmatte 2, bei der in Querrichtung 2b jeweils zwei geschlossene Leiterschleifen 4 einander überlappen. Die beiden Leiterschleifen überlappen dazu ebenfalls in Längsrichtung 2a. Darüber hinaus folgen in Längsrichtung 2a jeweils aufeinander dieselben Anordnungen der Leiterschleifen 4 aufeinander.

Fig. 7b zeigt eine als Endlosband gebildete Magnetfeldabschirmmatte 2, bei der in Längsrichtung jeweils geschlossene Leiterschleifen 4 einander überlappend nebeneinander angeordnet sind. In Querrichtung 2b sind die Leiterschleifen 4 versetzt zueinander angeordnet.

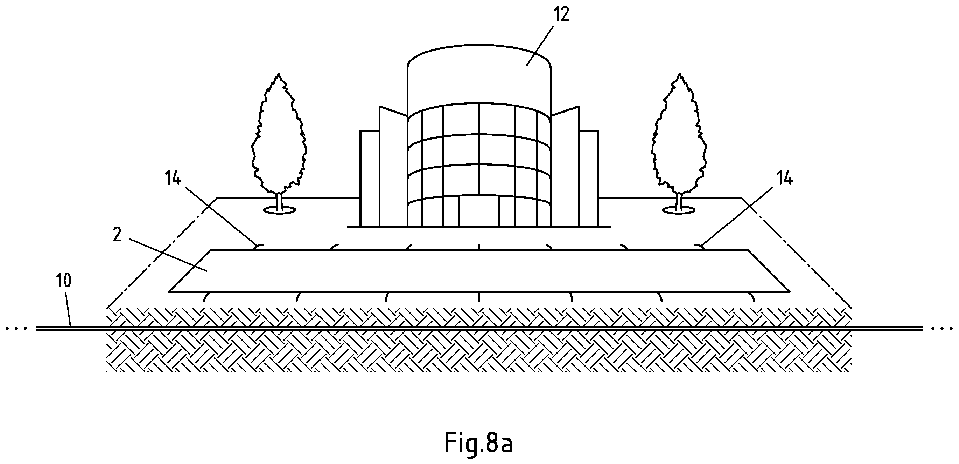

Fig. 8a zeigt schematisch eine onshore Anordnung. Ein im Tiefbau verlegtes Hochspannungskabel 10 wird im Bereich eine sensiblen Infrastruktur 12 mit einer Magnetfeldabschirmmatte 2 abgedeckt. Die Magnetfeldabschirmmatte 2 verläuft dabei in Längsrichtung 2a entlang der Erstreckungsrichtung des Kabels 10. Die Magnetfeldabschirmmatte 2 ist mittels Haken 14 am Boden fixiert. Das Hochspannungskabel 10 und die Magnetfeldabschirmmatte 2 können beide mit Erde oder Oberbodenmaterial bedeckt sein.

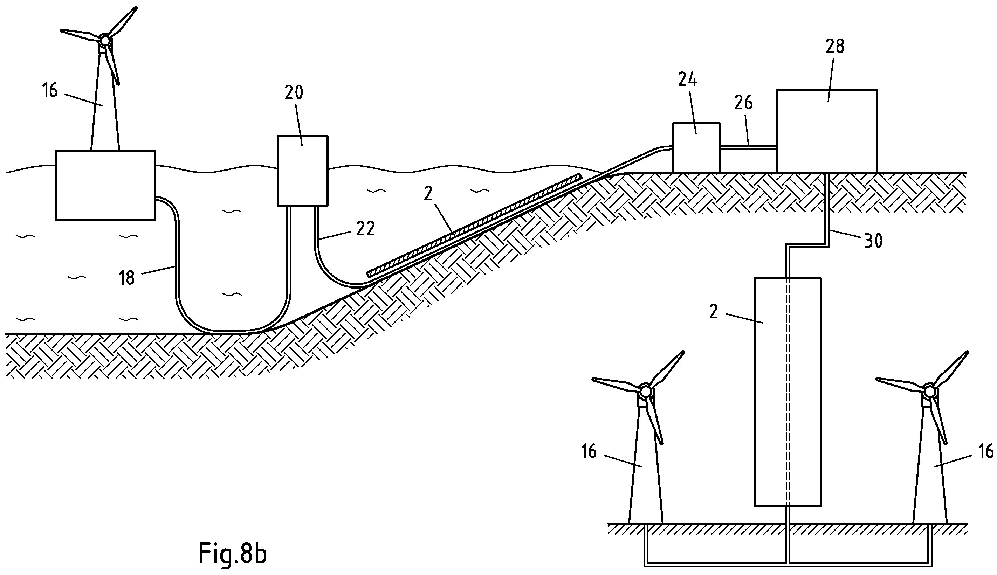

Fig. 8b zeigt ein weiteres Beispiel. Eine Windkraftanlage 16 ist über ein Seekabel 18 mit einer Substation 20 verbunden. Das Seekabel 16 kann teilweise schwimmend verlegt sein. Mehrere Windkraftanlagen 16 können mit der Substation 20 verbunden sein. In der Substation wird ein Anschlusskabel 22 angeschlossen, über welches die Leistung der mehreren Windkraftanlagen zu einer Transition Joint Bay (TJB) 24 übertragen wird.

Dieses Anschlusskabel 22 überträgt elektrische Leistung von mehreren 10 MW.

Die dabei auftretenden Ströme können erheblich sein. Daher wird das Kabel 22 mit Hilfe einer Magnetfeldabschirmmatte 2 zumindest in ökologisch sensiblen Bereichen, wie z.B. in Küstennähe, abgedeckt. Vom TJB 24 kann ein Kabel 26 zu einer Umspannstation 28 verlaufen. An die Umspannstation 28 kann eine onshore Windkraftanlage 16 oder ein Windpark angeschlossen sein. Auch hier kann ein Kabel 30 zwischen der Windkraftanlage 16 und der Umspannstation 28 mit Hilfe einer Magnetfeldabschirmmatte 2 abgeschirmt sein.

## Patentansprüche

1. Magnetfeldabschirmmatte mit
- zumindest einem drahtförmigen Leiter mit einem Leiterkern aus einem elektrisch leitfähigen Material und einer dem Leiterkern zumindest in Teilen umgebenden elektrischen Isolation aus einem elektrisch isolierenden Material, und
- zumindest zwei aus dem Leiter gebildeten, flächig angeordneten Leiterschleife, wobei
- zumindest die zumindest zwei der Leiterschleifen in der Art eines Endlosbandes zumindest mechanisch miteinander verbunden sind.

2. Magnetfeldabschirmmatte nach Anspruch 1,
**dadurch gekennzeichnet,**
- **dass** der Leiter in der Leiterschleife mäanderförmig mit wechselseitig im Wesentlichen parallel zueinander verlaufenden Abschnitten verläuft.

3. Magnetfeldabschirmmatte nach Anspruch 1 oder 2,
**dadurch gekennzeichnet,**
- **dass** zumindest zwei Bereiche der Leiterschleife mit bevorzugt jeweils mäanderförmigen, wechselseitig im Wesentlichen parallel zueinander verlaufenden Leitern entlang einer Längsrichtung der Leiterschleife gespiegelt sind.

4. Magnetfeldabschirmmatte nach einem der vorangehenden Ansprüche,
**dadurch gekennzeichnet,**
- **dass** zumindest zwei Bereiche der Leiterschleife mit bevorzugt jeweils mäanderförmigen, wechselseitig im Wesentlichen parallel zueinander verlaufenden Leitern entlang einer Querrichtung der Leiterschleife gespiegelt sind.

5. Magnetfeldabschirmmatte nach einem der vorangehenden Ansprüche,
**dadurch gekennzeichnet,**
- **dass** die Leiterschleife elektrisch geschlossen ist.

6. Magnetfeldabschirmmatte nach einem der vorangehenden Ansprüche,
**dadurch gekennzeichnet,**
- **dass** der Leiter der Leiterschleife an seinen Enden mit einem elektrischen Treiber verbunden ist, wobei der Treiber dazu eingerichtet ist, einen elektrischen Strom in den Leiter einzuspeisen.

7. Magnetfeldabschirmmatte nach einem der vorangehenden Ansprüche,
**dadurch gekennzeichnet,**
- **dass** die Leiterschleife mit einem Flächengebilde verbunden ist, insbesondere dass die Leiterschleife mit einem textilen Flächengebilde verbunden ist.

8. Magnetfeldabschirmmatte nach einem der vorangehenden Ansprüche,
**dadurch gekennzeichnet,**
- **dass** die Leiterschleife mit einem wasserdurchlässigen Flächengebilde verbunden ist.

9. Magnetfeldabschirmmatte nach einem der vorangehenden Ansprüche,
**dadurch gekennzeichnet,**
- **dass** die Leiterschleife aus miteinander verbundenen Maschen gebildet ist, insbesondere dass die Leiterschleife aus miteinander verbundenen Maschen mit einer Maschenweite von mehr als 2cm und weniger als 10cm, insbesondere zwischen 2 und 5cm gebildet.

10. Magnetfeldabschirmmatte nach einem der vorangehenden Ansprüche,
**dadurch gekennzeichnet,**
- **dass** die Leiterschleife als Kettenmatte gebildet ist.

11. Magnetfeldabschirmmatte nach einem der vorangehenden Ansprüche,
**dadurch gekennzeichnet,**
- **dass** die Leiterschleife eine Erstreckung in einer Längsrichtung des Endlosbandes aufweist, welche um zumindest einen Faktor 2, bevorzugt um einen Faktor 5 größer ist als eine Erstreckung des Endlosbandes in einer Querrichtung.

12. Magnetfeldabschirmmatte nach einem der vorangehenden Ansprüche,
**dadurch gekennzeichnet,**
- **dass** das Endlosband als Kabelmarkierungsband gebildet ist.

13. System mit einer Magnetfeldabschirmmatte nach einem der vorangehenden Ansprüche, und zumindest einem Befestigungsmittel, wobei das Befestigungsmittel zur mechanischen Fixierung der Magnetfeldabschirmmatte am Untergrund, insbesondere in Form eines Hakens, Herings oder Gewichts gebildet ist und/oder wobei das Befestigungsmittel zur mechanischen Fixierung der Magnetfeldabschirmmatte an einem unterhalb der Magnetabschirmmatte verlaufenden Kabel gebildet ist.

14. System nach Anspruch 13 bei dem unterhalb der Magnetfeldabschirmmatte ein Kabel verlegt ist und die Magnetfeldabschirmmatte in ihrer Längserstreckung des Endlosbandes im Wesentlichen entlang einer Längserstreckung des Kabels verlegt ist.

15. System nach Anspruch 13 oder 14 bei dem zumindest zwei Magnetfeldabschirmmatten in Längsrichtung des Endlosbandes nebeneinander verlegt sind, insbesondere dass die Überdeckung zumindest 10% und maximal 50% einer jeweiligen Quererstreckung beträgt.
